# EUROPEAN PATENT APPLICATION

(11) **EP 4 641 638 A1**
(43) Date of publication of application: **29.10.2025**
(21) Application number: 24200788.8
(22) Date of filing: 17.09.2024
(51) Int. Cl.: H01L 25/065, H01L 23/00, H01L 25/16, H01L 25/18, G06F 1/18, G06F 13/40, H01L 21/98, H01L 25/10

(54) **CHIP AND ELECTRONIC DEVICE**

(30) Priority: 28.04.2024 CN 202410525852
(71) Applicant: Beijing X-Ring Technology Co., Ltd., Beijing 100085 (CN)
(72) Inventor: ZHANG, Xiaodong, Beijing, 100085 (CN); WANG, Teng, Beijing, 100085 (CN); CAI, Tao, Beijing, 100085 (CN); WANG, Liqiang, Beijing, 100085 (CN); JING, Xiangmeng, Beijing, 100085 (CN); HE, Jianbo, Beijing, 100085 (CN)
(74) Representative: Stöckeler, Ferdinand

(57) **Abstract**

A chip includes a first chip component and a second chip component. The first chip component includes one or more processor units. The second chip component includes one or more integrated passive devices and one or more memories. At least one of the integrated passive devices is connected to at least one of the processor units, and at least one of the memories is connected to at least one of the processor units. According to the chip of the present invention, the integrated passive device of the second chip component is connected to the processor unit of the first chip component, thereby utilizing the high capacitance density of the integrated passive component to provide the sufficient capacitance density of decoupling capacitor and the lower equivalent series inductance value for the processor unit; and the memory of second chip component is connected to the processor unit of the first chip component, so that the memory can provide high-capacity, low latency data reading and storage for the processor unit.

## Description

### TECHNICAL FIELD

The present invention relates to the field of semiconductor technologies, and particularly relates to a chip and an electronic device.

### BACKGROUND

The most typical feature of a mobile system on chip (SoC) is on-chip heterogeneity, which satisfies complex and diverse mobile application requirements through different on-chip heterogeneous processors. With increasing of complexity of the application and continuous improvement of the process, there are various problems for the on-chip heterogeneous processors, such as an insufficient capacitance density of decoupling capacitor, a high equivalent series inductance (ESL) value, a low capacity, and an increased latency in data storage and reading.

### SUMMARY

The present invention proposes a chip to improve the capacitance density of the chip and reduce the equivalent inductance of the chip.

According to a first aspect of embodiments of the present invention, there is provided a chip. The chip includes a first chip component and a second chip component. The first chip component includes one or more processor units. The second chip component includes one or more integrated passive devices and one or more memories. At least one of the integrated passive devices is connected to at least one of the processor units, and at least one of the memories is connected to at least one of the processor units.

Optionally, the first chip component and the second chip component are arranged in stack, and at least one of the integrated passive devices is arranged facing at least one of the processor units.

Optionally, the second chip component includes a power gating cell, at least one of the processor units is a central processing unit, and the power gating cell is arranged facing the central processing unit and connected to the central processing unit.

Optionally, the central processing unit includes a first portion and a second portion, the power gating cell is arranged facing the first portion and connected to the first portion, and at least one of the integrated passive devices is a first integrated passive device that is arranged facing the second portion and connected to the second portion. The first integrated passive device is integrated with the power gating cell to form a first integrated unit.

Optionally, there is more than one integrated passive device, at least one of the more than one integrated passive devices is a second integrated passive device, the first chip component includes at least one interface, and the second integrated passive device is arranged facing the interface and connected to the interface.

Optionally, at least one of the processor units is a graphics processing unit, at least one of the memories is a dynamic random access memory that is arranged facing the graphics processing unit and connected to the graphics processing unit; and/or at least one of the processor units is a neural network processing unit, and the second chip component further includes a processing in memory module that is arranged facing the neural network processing unit and connected to the neural network processing unit.

Optionally, the first chip component and the second chip component are connected through hybrid bonding.

Optionally, there is more than one second chip component, and the more than one second chip components are arranged on a same side of the first chip component in a thickness direction of the chip and is arranged in stack.

Optionally, at least one of the processor units is a graphics processing unit, at least one of the memories is a dynamic random access memory, and the dynamic random access memory is connected to the graphics processing unit.

Optionally, the chip includes a first chip layer, a second chip layer and a third chip layer that are sequentially arranged in stack, the graphics processing unit is arranged in the first chip layer, the dynamic random access memory includes a peripheral circuit and a memory cell array, the peripheral circuit is arranged in the second chip layer, and the memory cell array and the integrated passive devices are both arranged in the third chip layer; and the peripheral circuit is arranged facing the graphics processing unit and connected to the graphics processing unit, and the memory cell array is arranged facing the peripheral circuit and connected to the peripheral circuit.

Optionally, there is more than one processor unit, and at least one of the more than one processor units is a central processing unit; and the central processing unit includes a first cache portion and a second cache portion, the first cache portion is arranged in the first chip layer, the second cache portion is arranged in the second chip layer, and the second cache portion is arranged facing the first cache portion and connected to the first cache portion.

Optionally, the second chip component includes a power gating cell that is arranged in the third chip layer, and the power gating cell is arranged facing the second cache portion and connected to the second cache portion.

Optionally, the second cache portion includes a first sub-portion and a second sub-portion, the power gating cell is arranged facing the first sub-portion and connected to the first sub-portion, at least one of the integrated passive devices is a first integrated passive device that is arranged facing the second sub-portion and connected to the second sub-portion, and the first integrated passive device is integrated with the power gating cell to form a second integrated unit.

Optionally, the first chip component includes at least one interface that is arranged in the first chip layer, and at least one of the integrated passive devices is a second integrated passive device that is arranged facing the interface and connected to the interface.

Optionally, there is more than one processor unit, at least one of the more than one processor units is a neural network processing unit that is arranged in the first chip layer, the second chip component further includes a processing in memory module that is arranged in the second chip layer, the processing in memory module is arranged facing the neural network processing unit and connected to the neural network processing unit, and the processing in memory module is integrated with the peripheral circuit to form a third integrated unit.

Optionally, there is more than one third chip layer, and the more than one third chip layers are arranged on a same side of the second chip layer in a thickness direction of the chip and is arranged in stack.

Optionally, the first chip layer and the second chip layer are connected through hybrid bonding; and the second chip layer and the third chip layer are connected through hybrid bonding.

Optionally, the integrated passive device is in power ground connection with the first chip component, and the dynamic random access memory is in signal ground connection with the first chip component.

Optionally, the chip further includes a packaging layer, and the first chip component and the second chip component are arranged within the packaging layer.

According to a second aspect of embodiments of the present invention, there is provided an electronic device.

The electronic device includes a circuit board, and a chip as described in the first aspect. The chip is connected to the circuit board.

According to the chip of the present invention, the integrated passive device of the second chip component is connected to the processor unit of the first chip component, thereby utilizing the high capacitance density of the integrated passive component to provide the sufficient capacitance density of decoupling capacitor and the lower equivalent series inductance value for the processor unit; and the memory of second chip component is connected to the processor unit of the first chip component, so that the memory can provide high-capacity, low latency data reading and storage for the processor unit.

### BRIEF DESCRIPTION OF THE DRAWINGS

Fig. 1 is a schematic diagram of an assembly structure of a first chip component and a second chip component of a chip according to an embodiment of the present invention.
Fig. 2 is a schematic diagram of an assembly structure of a first chip component and a second chip component of a chip according to an embodiment of the present invention.
Fig. 3 is a schematic diagram of an assembly structure of a first chip component and a second chip component of a chip according to an embodiment of the present invention.
Fig. 4 is a schematic diagram of an assembly structure of a first chip component and a second chip component of a chip according to an embodiment of the present invention.
Fig. 5 is a schematic diagram of an assembly structure of a first chip component and a second chip component of a chip according to an embodiment of the present invention.
Fig. 6 is a schematic diagram of a structure of a chip according to an embodiment of the present invention.
Fig. 7 is a schematic diagram of a structure of a chip according to another embodiment of the present invention.
Fig. 8 is a manufacturing process diagram of a chip according to an embodiment of the present invention.

Figure references:
1, a first chip component; 11, a central processing unit; 111, a first portion; 112, a second portion; 113, a first cache portion; 114, a second cache portion; 12, a graphics processing unit; 13, a neural network processing unit; 14, an interface; 101, a first chip layer; 102, a second chip layer; 103, a third chip layer;
2, a second chip component; 21, an integrated passive device; 211, a first integrated passive device; 212, a second integrated passive device; 22, a dynamic random access memory; 221, a peripheral circuit; 222, a memory cell array; 23, a power gating cell; 24, a processing in memory module; 25, a through silicon via; 201, a first integrated unit; 202, a second integrated unit; 203, a third integrated unit;
3, a packaging layer;
4, a substrate;
5, a low power double data rate SDRAM (LPDDR);
6, a first pin;
7, a second pin;
8, a third pin;
9. a fourth pin;
10, a copper pillar;
20, a connection board.

### DETAILED DESCRIPTION

Embodiments of the present invention are described in details below, and examples of which are shown in the accompanying drawings. The embodiments described below with reference to the accompanying drawings are exemplary and intended to explain the present invention, and should not be construed as limiting the present invention.

In related art, an on-chip heterogeneous processor faces at least the following issues:
(1) Peak performance of a single core central processing unit (CPU) requires a higher frequency, and with the advancement of technical process, power density and power integrity (PI) issues are becoming increasingly severe. Transient issues caused by a demand for low power consumption and fast response in applications have led to a more severe PI problem. The capacitance density of on-chip coupling capacitor is insufficient, and a cost of metal-insulator-metal capacitor (MIM cap)/metal-oxide-metal capacitor (MOM cap) is relatively high;
(2) A gaming scene peak bandwidth demand of a graphics processing unit (GPU) far exceeds a bandwidth capacity provided by a low power double data rate SDRAM (LPDDR), resulting in an increased latency for data storage and reading. Therefore, how to improve GPU bandwidth and reduce data latency is an urgent technical problem that needs to be solved;
(3) For a neural network processing unit (NPU), a tensor part bears the largest computation and memory access requirements. How to reduce the computation pressure on the tensor part is currently an urgent technical problem that needs to be solved.

In order to solve the above problems, the present invention proposes a chip and an electronic device to improve the capacitance density of decoupling capacitor of the chip, reduce the latency of data storage and reading, enhance the computing capability of the chip, and reduce the power consumption of the chip.

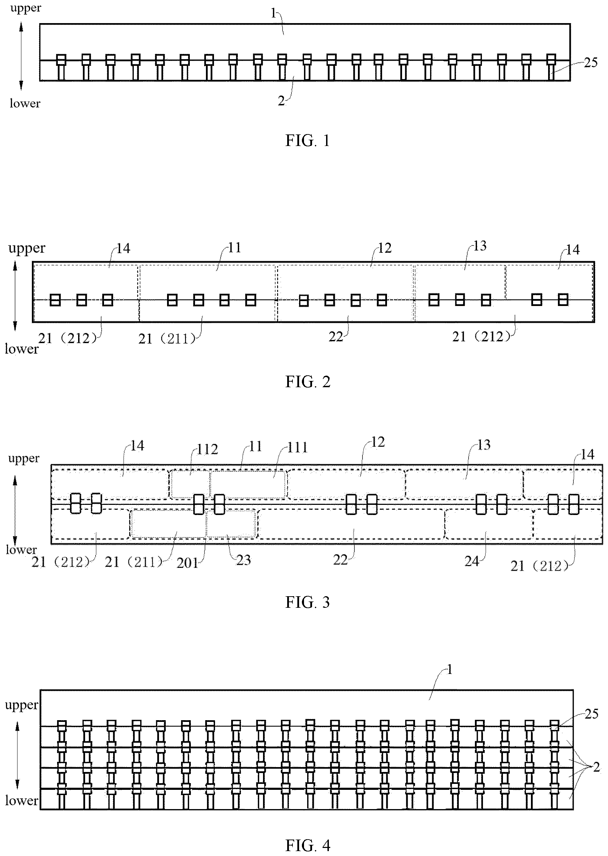

As shown in Figures 1 to 5, the chip of the present invention includes a first chip component 1 and a second chip component 2. The first chip component 1 includes one or more processor units, and the second chip component 2 includes one or more integrated passive devices (IPDs) 21 and one or more memories. At least one integrated passive device 21 is connected to at least one processor unit, and at least one memory is connected to at least one processor unit.

The first chip component 1 may be a SoC. The processor unit may be a central processing unit 11, a graphics processing unit 12, or a neural network processing unit 13. The memory may be a dynamic random access memory (DRAM) 22 or a static random access memory (SRAM). For example, as shown in Fig. 2, the central processing unit 11 is connected to the integrated passive device 21, the graphics processing unit 12 is connected to the dynamic random access memory 22, and the neural network processing unit 13 is connected to the integrated passive device 21.

In the chip of the present invention, the integrated passive device 21 of the second chip component 2 is connected with the processor unit of the first chip component 1, thereby utilizing the high capacitance density of the integrated passive device 21 to provide the sufficient capacitance density of decoupling capacitor and the lower equivalent series inductance value for the processor unit; the memory of the second chip component 2 is connected with the processor unit of the first chip component 1, so that the memory can provide high-capacity, low latency data reading and storage for the processor unit.

As shown in Figs. 1 to 4, the first chip component 1 and the second chip component 2 are arranged in stack, and at least one integrated passive device 21 is arranged facing at least one processor unit.

For example, as shown in Figs. 1 and 4, the first chip component 1 is arranged on an upper side of the second chip component 2. The first chip component 1 and the second chip component 2 are interconnected through a through silicon via (TSV) 25 and a pad. The direction from upper to lower is shown in Figs. 1 to 4.

By arranging the first chip component 1 and the second chip component 2 in stack, the vertical interconnection can be achieved between the integrated passive device 21 and the processor unit, which facilitates the connection between the integrated passive device 21 and the processor unit.

Optionally, as shown in Fig. 3, the second chip component 2 includes a power gating cell 23, at least one processor unit is the central processing unit 11, and the power gating cell 23 is arranged facing the central processing unit 11and connected to the central processing unit 11.

The power gating cell 23 is arranged facing the central processing unit 11, which can be understood as: at least a part of the power gating cell 23 is arranged directly facing at least a part of the central processing unit 11 in a thickness direction of the chip. In other words, the orthographic projection of the power gating cell 23 in a direction towards the first chip component 1 covers at least a part of the central processing unit 11. For example, as shown in Fig. 3, at least a part of the power gating cell 23 is arranged directly below the central processing unit 11.

By arranging the power gating cell 23 on the second chip component 2, the central processing unit 11 and the power gating cell 23 are arranged on different layers of the chip. This can reduce the impact of the power gating cell 23 on the utilization rate and current voltage of the central processing unit 11, and also can reduce the number of metal layers in the first chip component 1, thereby reducing the cost of the first chip component 1. In addition, the power gating cell 23 arranging facing the central processing unit 11 enables the vertical interconnection between the power gating cell 23 and the central processing unit 11, which facilitates the connection between the power gating cell 23 and the central processing unit 11.

Optionally, as shown in Fig. 3, the central processing unit 11 includes a first portion 111 and a second portion 112. The power gating cell 23 is arranged facing the first portion 111 and connected to the first portion 111. At least one integrated passive component 21 is a first integrated passive component 211 that is arranged facing the second portion 112 and connected to the second portion 112. The first integrated passive component 211 is integrated with the power gating cell 23 to form a first integrated unit 201.

By integrating the first integrated passive device 211 with the power gating cell 23, the volume of the second chip component 2 occupied by the first integrated passive device 211 and the power gating cell 23 can be reduced, and the capacity of the remaining parts of the second chip component 2 can be increased.

Optionally, as shown in Figs. 2 and 3, there is more than one integrated passive device 21, with at least one of the more than one integrated passive devices 21 being a second integrated passive device 212. The first chip component 1 includes at least one interface (I/F) 14, and the second integrated passive device 212 is arranged facing the interface 14 and connected to the interface 14. The interface 14 is used for a connection between the chip and an external device.

The second integrated passive device 212 is arranged facing the interface 14, which can be understood as: at least a part of the second integrated passive device 212 is arranged directly facing at least a part of the interface 14 in a thickness direction of the chip. In other words, the orthographic projection of the second integrated passive component 212 in a direction towards the first chip component 1 covers at least a part of the interface 14. For example, as shown in Fig. 3, at least a part of the second integrated passive component 212 is arranged directly below the interface 14.

By arranging the interface 14 in the first chip component 1, it is convenient for interface 14 to connect with an external device. By arranging the second integrated passive component 212 facing the interface 14 and connecting the second integrated passive component 212 to the interface 14, the vertical interconnection between the second integrated passive component 212 and interface 14 can be achieved, which facilitates the connection between the second integrated passive component 212 and the interface 14.

Optionally, as shown in Figs. 2 to 5, at least one processor unit is a graphics processing unit 12, at least one memory is a dynamic random access memory 22, and the dynamic random access memory 22 is connected to the graphics processing unit 12.

By connecting the graphics processing unit 12 with the dynamic random access memory 22, the dynamic random access memory 22 can provide large capacity and low latency data reading and storage for the graphics processing unit 12. The dynamic random access memory 22 exists as a heterogeneous memory outside of the first chip component 1, meeting the high bandwidth requirements for specific data access in peak scenes.

Optionally, as shown in Figs. 2 and 3, the dynamic random access memory 22 is arranged facing the graphics processing unit 12.

The dynamic random access memory 22 is arranged facing the graphics processing unit 12, which can be understood as: at least a part of the dynamic random access memory 22 is arranged directly facing at least a part of the graphics processing unit 12 in a thickness direction of the chip. In other words, the orthographic projection of the dynamic random access memory 22 in a direction towards the first chip component 1 covers at least a part of the graphics processing unit 12. For example, as shown in Figs. 2 and 3, at least a part of the dynamic random access memory 22 is arranged directly below the graphics processing unit 12.

The dynamic random access memory 22 is arranged facing the graphics processing unit 12, enabling the vertical interconnection between the dynamic random access memory 22 and the graphics processing unit 12, which facilitates the connection between the dynamic random access memory 22 and the graphics processing unit 12.

Optionally, the first chip component 1 is fabricated using logic process, while the second chip component 2 is fabricated using DRAM process.

The power gating cell 23 is integrated into the second chip component 2. Although it increases the number of metal layers in the second chip component 2, the goal of reducing the overall cost of the chip can be achieved, due to lower process cost of the second chip component 2 compared to the first chip component 1.

Optionally, as shown in Fig. 3, at least one processor unit is a neural network processor 13, and the second chip component 2 also includes a processing in memory (PIM) module 24, which is arranged facing the neural network processor 13 and is connected to the neural network processor 13.

By connecting the neural network processor 13 with the processing in memory module 24, a portion of the tensor calculation tasks of the neural network processor 13 can be offloaded to the processing in memory module 24, thereby reducing the computation pressure of the neural network processor 13 and improving the computation efficiency of the chip.

Optionally, as shown in Fig. 4, there is more than one second chip component 2. The more than one second chip components 2 are arranged in stack and is arranged on a same side of the first chip component 1 in a thickness direction of the chip.

The structures of more than one second chip components 2 may be the same or different. Two adjacent second chip components 2 may be vertically interconnected, or two non-adjacent second chip components 2 may be vertically interconnected.

By providing more than one second chip components 2, the more than one second chip components 2 can provide larger capacity, lower latency data reading and storage for the processor unit, and meet the requirements of multi-scene and large model applications without integrating LPDDR, which saves the chip cost.

Optionally, the first chip component 1 and the second chip component 2 are connected through hybrid bonding.

The hybrid bonding connection between the first chip component 1 and the second chip component 2 can achieve higher density and larger bandwidth.

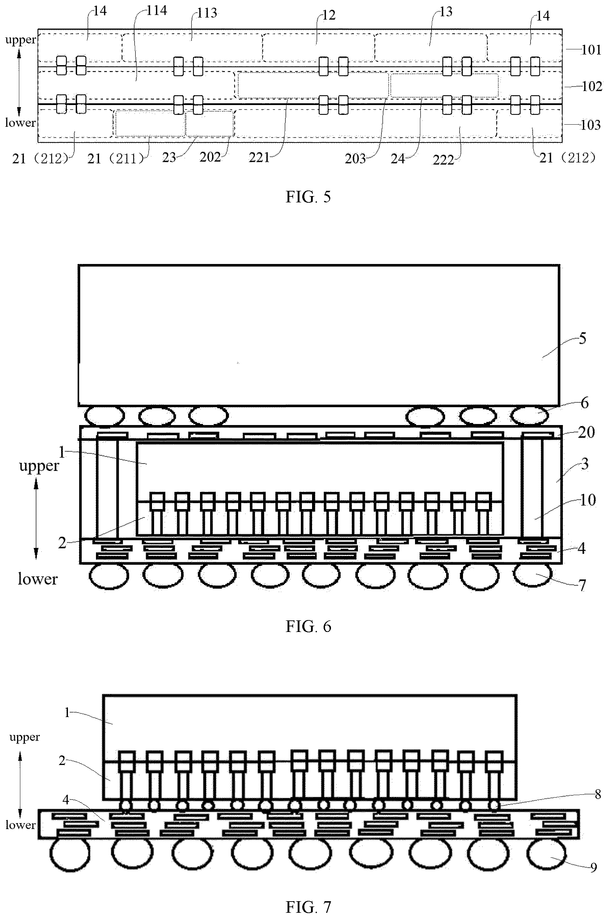

Optionally, as shown in Fig. 5, the chip includes a first chip layer 101, a second chip layer 102, and a third chip layer 103 sequentially arranged in stack. The graphics processing unit 12 is arranged in the first chip layer 101, and the dynamic random access memory 22 includes a peripheral circuit 221 and a memory cell array 222. The peripheral circuit 221 is arranged in the second chip layer 102, and the memory cell array 222 and the integrated passive device 21 are both arranged in the third chip layer 103. The peripheral circuit 221 is arranged facing the graphics processing unit 12 and connected to the graphics processing unit 12, and the memory cell array 222 is arranged facing the peripheral circuit 221 and connected to the peripheral circuit 221.

For example, as shown in Fig. 5, the first chip layer 101 is arranged on an upper side of the second chip layer 102, and the second chip layer 102 is arranged on an upper side of the third chip layer 103. The direction from upper to lower is shown in Fig. 5.

The peripheral circuit 221 is arranged facing the graphics processing unit 12, which can be understood as: at least a part of the peripheral circuit 221 is arranged directly facing at least a part of the graphics processing unit 12 in a thickness direction of the chip. In other words, the orthographic projection of the peripheral circuit 221 in a direction towards the first chip layer 101 covers at least a part of the graphics processing unit 12. For example, as shown in Fig. 5, at least a part of the peripheral circuit 221 is arranged directly below the graphics processing unit 12.

The memory array cell 222 is arranged facing the peripheral circuit 221, which can be understood as: at least a part of the memory array cell 222 is arranged directly facing at least a part of the peripheral circuit 221 in a thickness direction of the chip. In other words, the orthographic projection of the memory array cell 222 in a direction towards the second chip layer 102 covers at least a part of the peripheral circuit 221. For example, as shown in Fig. 3, at least a part of the memory array cell 222 is arranged directly below the peripheral circuit 221.

By arranging the peripheral circuit 221 of the dynamic random access memory 22 on the second chip layer 102 and arranging the memory array cell 222 of the dynamic random access memory 22 on the third chip layer 103, respectively, the separation of the peripheral circuit 221 and the memory array cell 222 is achieved, thereby increasing the capacity of the dynamic random access memory 22, which can provide graphics processing unit 12 with larger capacity and lower latency for data reading and storage.

Optionally, as shown in Fig. 5, the central processing unit 11 includes a first cache portion 113 and a second cache portion 114. The first cache portion 113 is arranged in the first chip layer 101, the second cache portion 114 is arranged in the second chip layer 102, and the second cache portion 114 is arranged facing the first cache portion 113 and connected to the second cache portion 113.

The second cache portion 114 is arranged facing the first cache portion 113, which can be understood as: at least a part of the second cache portion 114 is arranged directly facing at least a part of the first cache portion 113 in a thickness direction of the chip. In other words, the orthographic projection of the second cache portion 114 in a direction towards the first chip layer 101 covers at least a part of the first cache portion 113. For example, as shown in Fig. 5, at least a part of the second cache portion 114 is arranged directly below the first cache portion 113.

The central processing unit 11 includes a primary storage, a secondary storage, and a tertiary storage. The first cache portion 113 may include the primary storage and the secondary storage, and the second cache portion 114 may include the tertiary storage. The tertiary storage may be a static random access memory (SRAM).

By arranging the first cache portion 113 of the central processing unit 11 on the first chip layer 101 and arranging the second cache portion 114 of the central processing unit 11 on the second chip layer 102, respectively, and separating the second cache portion 114 of the central processing unit 11 into the second chip layer, sufficient space can be provided for the first cache portion 113 of the central processing unit 11, and the process cost of the central processing unit 11 can be reduced, thereby lowering the cost of the chip.

Optionally, as shown in Fig. 5, the second chip component 2 includes a power gating cell 23, which is arranged in the third chip layer 103. The power gating cell 23 is arranged facing the second cache portion 114 and is connected to the second cache portion 114.

The power gating cell 23 is arranged facing the second cache portion 114, which can be understood as: at least a part of the power gating cell 23 is arranged directly facing at least a part of the second cache portion 114 in a thickness direction of the chip. In other words, the orthographic projection of the power gating cell 23 in a direction towards the second chip layer 102 covers at least a part of the second cache portion 114. For example, as shown in Fig. 5, at least a part of the power gating cell 23 is arranged directly below the second cache portion 114.

By arranging the power gating cell 23 on the third chip layer 103, the power gating cell 23 and the central processing unit 11 are arranged in different layers of the chip. This can reduce the impact of the power gating cell 23 on the utilization rate and current voltage of the central processing unit 11, and also the number of metal layers in the first chip layer 101 and the second chip layer 102 can also be reduced, thereby lowering the cost of the first chip component 1. In addition, the power gating cell 23 is arranged facing the second cache portion 114, enabling the vertical interconnection between the power gating cell 23 and the second cache portion 114, which facilitates the connection between the power gating cell 23 and the central processing unit 11.

Optionally, as shown in Fig. 5, the second cache portion 114 includes a first sub-portion and a second sub-portion. The power gating cell 23 is arranged facing the first sub-portion and connected to the first sub-portion. At least one integrated passive device 21 is the first integrated passive device 211, which is arranged facing the second sub-portion and connected to the second sub-portion. The first integrated passive component 211 is integrated with the power gating cell 23 to form a second integrated unit 202.

The power gating cell 23 is arranged facing the first sub-portion, which can be understood as: at least a part of the power gating cell 23 is arranged directly facing at least a part of the first sub-portion in a thickness direction of the chip. In other words, the orthographic projection of the power gating unit 23 in a direction towards the second chip layer 102 covers at least a part of the first sub-portion. For example, as shown in Fig. 3, at least a part of the power gating cell 23 is arranged directly below the first sub-portion.

The first integrated passive device 211 is arranged facing the second sub-portion, which can be understood as: at least a part of the first integrated passive device 211 is arranged directly facing at least a part of the second sub-portion in a thickness direction of the chip. In other words, the orthographic projection of the first integrated passive device 211 in a direction forwards the second chip layer 102 covers at least a part of the second sub-portion. For example, as shown in Fig. 3, at least a part of the first integrated passive device 211 is arranged directly below the second sub-portion.

By arranging the power gating cell 23 facing the first sub-portion, the vertical interconnection between the power gating cell 23 and the first sub-portion can be achieved; by arranging the first integrated passive device 211 facing the second sub-portion, the vertical interconnection between the first integrated passive device 211 and the second sub-portion can be achieved, which facilitates the connection between the power gating cell 23 and the first integrated passive component 211 and the central processing unit 11.

Optionally, as shown in Fig. 3, the first chip component 1 includes at least one interface 14, which is arranged in the first chip layer 101. At least one integrated passive device 21 is the second integrated passive device 212, which is arranged facing the interface 14 and connected to the interface 14.

By arranging the interface 14 on the first chip layer 101, it is convenient for the interface 14 to connect with an external device.

Optionally, as shown in Fig. 5, at least one processor unit is a neural network processor 13, which is arranged in the first chip layer 101. The second chip component 2 also includes a processing in memory module 24, which is arranged in the second chip layer 102. The processing in memory module 24 is arranged facing the neural network processor 13 and is connected to the neural network processor 13. The processing in memory module 24 is integrated with the peripheral circuit 221 to form a third integrated unit 203.

By connecting the neural network processor 13 with the processing in memory module 24, a part of the tensor calculation tasks of the neural network processor 13 can be offloaded to the processing in memory module 24, thereby reducing the computation pressure of the neural network processor 13 and improving the computation efficiency of the chip. In addition, by integrating the processing in memory module 24 with the peripheral circuit 221, the volume of the second chip layer 102 occupied by the processing in memory module 24 and the peripheral circuit 221 can be reduced, and the capacity of the remaining parts of the second chip layer 102 can be increased.

Optionally, there is more than one third chip layer 103, and the more than one third chip layers 103 are arranged in stack and arranged on a same side of the second chip layer 102 in a thickness direction of the chip.

The structures of the more than one third chip layers 103 can be the same or different. Two adjacent third chip layers 103 can be vertically interconnected, or two non-adjacent third chip layers 103 can be vertically interconnected.

By arranging more than one third chip layers 103, the more than one third chip layers 103 can provide larger capacity for the processor units, as well as lower latency for data reading and storage, and meet the requirements of multi-scenario and large model applications without integrating LPDDR, which saves the chip cost.

Optionally, the first chip layer 101 and the second chip layer 102 are connected through hybrid bonding. The second chip layer 102 and the third chip layer 103 are connected through hybrid bonding.

By connecting the first chip layer 101 and the second chip layer 102 through hybrid bonding, and connecting the second chip layer 102 and the third chip layer 103 through hybrid bonding, higher density and larger bandwidth can be achieved.

Optionally, the integrated passive device 21 is in power ground connection with the first chip component 1, achieving electrical connection between the integrated passive device 21 and the first chip component 1. The dynamic random access memory 22 is in signal ground connection with the first chip component 1, achieving signal connection between the dynamic random access memory 22 and the first chip component 1.

Through the power ground connection between the integrated passive component 21 and the first chip component 1, and the signal ground connection between the dynamic random access memory 22 and the first chip component 1, the chip proposed in the present invention can provide sufficient capacitance density and lower equivalent series inductance value, ensuring that the central processing unit 11 can operate at higher frequencies; using the dynamic random access memory 22 to store game scenes and render intermediate data, which increases the bandwidth of graphics processing unit 12 and reduces data latency; meanwhile, the dynamic random access memory 22 exists as the heterogeneous memory outside the first chip component 1, which further meets the high bandwidth requirements for specific data access in peak scenarios. In addition, the area occupied by the decoupling capacitor in the first chip component 1 can be reduced, avoiding the use of costly MIM/MOM, increasing the available area of each processor unit (such as the central processing unit 11, the graphics processing unit 12, etc.) and interface 14 in the first chip component 1, reducing or eliminating the decoupling capacitor on the packaged first chip component 1, and lowering the cost of the first chip component 1.

Optionally, as shown in Fig. 6, the chip also includes a packaging layer 3, and both the first chip component 1 and the second chip component 2 are located within the packaging layer 3. The packaging layer 3 may be a plastic packaging layer.

For example, as shown in Fig. 6, the chip includes a substrate 4. The first chip component 1 and the second chip component 2 are both arranged on a same side of the substrate 4 in a thickness direction, and the second chip component 2 is connected to the substrate 4. The packaging layer 3 is arranged on the side of the substrate 4 facing the second chip component 2, and side surfaces of both the first chip component 1 and the second chip component 2 are covered by the packaging layer 3.

By arranging the first chip component 1 and the second chip component 2 within the packaging layer 3, the packaging layer 3 can be used to protect the first chip component 1 and the second chip component 2, reducing the risk of breakage and rupture of the chip during transportation and assembly when subjected to external force.

Optionally, as shown in Fig. 6, the chip also includes an LPDDR 5, which is connected to the substrate 4.

For example, as shown in Fig. 6, the first chip component 1 is arranged on the upper side of the second chip component 2, the substrate 4 is arranged on the lower side of the second chip component 2, and the LPDDR 5 is arranged on the upper side of the first chip component 1. The substrate 4 is connected to a connection board 20 through a copper pillar 10, and the LPDDR 5 is connected to the connection board 20 through a first pin 6. The first pin 6 may be a solder bump, a solder ball, or a copper pillar. The direction from upper to lower is shown in Fig. 6.

By arranging the LPDDR 5, the bandwidth of the chip can be further improved to better meet the high bandwidth requirements for specific data access in peak scenarios.

Optionally, as shown in Fig. 6, the chip also includes a second pin 7, which is connected to the substrate 4 and configured for connecting to a circuit board. The second pin 7may be a solder ball.

Optionally, as shown in Fig. 7, the chip includes a substrate 4, the first chip component 1 and the second chip component 2 both arranged on a same side of the substrate 4 in a thickness direction, and the second chip component 2 is connected to the substrate 4. The side of the fourth substrate 4 facing the first chip component 1 is provided with a plastic packaging layer (not shown in the figure), which includes side surfaces of the first chip component 1 and the second chip component 2. The plastic packaging layer can also cover a surface of the first chip component 1 facing away from the second chip component 2.

For example, the first chip component 1 is arranged on the upper side of the second chip component 2, and the substrate 4 is arranged on the lower side of the second chip component 2. The second chip component 2 is connected to the substrate 4 through a third pin 8. A surface of the substrate 4 facing away from the second chip component 2 is provided with a fourth pin 9, which is configured to connect with a circuit board. The third pin 8 may be a solder bump, a solder ball, or a copper pillar. The fourth pin 9 may be a solder ball. The direction from upper to lower is shown in Fig. 7.

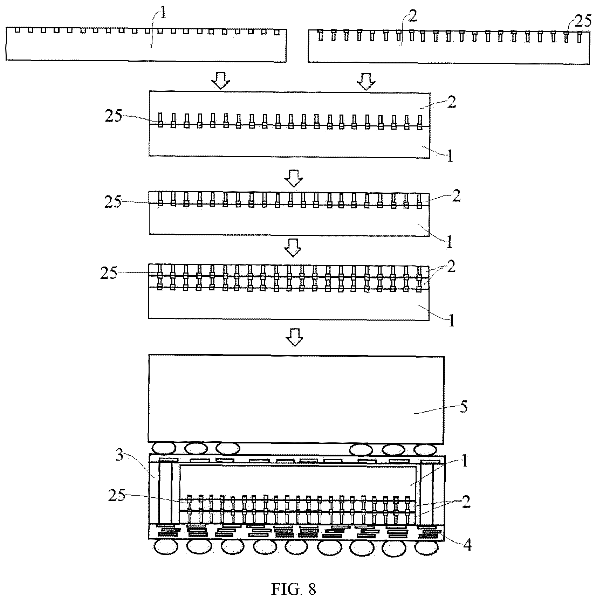

The manufacturing method of the chip of the present invention is described below with reference to Fig. 8:
providing a first die and a second die, and making a solder pad on the first die, and making a through silicon via 25 and a solder pad on the second die; in which the first die forms the first chip component 1, and the second die forms the second chip component 2;
welding the first die and the second die face to face together;
grinding the second die and exposing the through silicon via 25, and making a necessary solder pad;
repeating the above operation to stack a second layer of die; and
grinding a surface of the first die facing away from other dies after stacking, and integrating the stacked dies into the packaging layer 3.

The chip of the present invention has the following advantages.

The sufficient capacitance density and extremely low equivalent series inductance are provided, ensuring higher frequency operation required for the single core peak performance of the central processing unit 11 under advanced process.

The dynamic random access memory 22 is dedicated to storing game scenes and rendering intermediate data, enhancing the game scenes peak bandwidth of the graphics processing unit 12.

The key computation of the neural network processor 13 is run on the dynamic random access memory 22, improving computation capability and reducing power consumption.

The dynamic random access memory 22 exists as the heterogeneous memory outside of the main memory of the system level chip, providing high bandwidth requirements for peak scenario specific data access.

The integrated passive device 21 facing the central processing unit 11 integrates the power gating cell 23, which solves the impact of the power gating cell 23 on the utilization rate and current voltage of the central processing unit 11, and reduces the metal layer cost of the system level chip.

The area of the on-chip decoupling capacitor is reduced, avoiding use of the costly MIM/MOM, and increasing the available area of the processor unit and interface 14.

The use of packaging and board level decoupling capacitor is reduced or eliminated, reducing the cost and saving the area.

The peripheral circuit 221 of the dynamic random access memory 22 is separated from the memory array cell 222, increasing the capacity of the dynamic random access memory 22, and solving the cost problem of the advanced SRAM process for the central processing unit 11.

By stacking multiple layers of the second chip component 2 including the integrated passive devices 21 and the dynamic random access memory 22, it meets the requirements of multi-scenario and large model applications without integrating the LPDDR.

Wafer-to-wafer hybrid bonding stacking process is adopted, which reduces the chip stacking cost.

An electronic device of the present invention includes a circuit board and a chip. The chip is any chip as described in the above embodiments, and the chip is connected to the circuit board. The electronic devices may be a mobile phone, a tablet, a smart wearable device, a smart home device, and the like.

For example, the chip in Fig. 6 is soldered to the circuit board through the second pin 7, and the chip in Fig. 7 is soldered to the circuit board through the fourth pin 9.

Although the embodiments of the present invention have been shown and described above, it can be understood that the above embodiments are exemplary and should not be construed as limiting the present invention. Any changes, modifications, substitutions, and variations made by those skilled in the art to the above embodiments are within the scope of protection of the present invention.

## Claims

1. A chip, comprising:
a first chip component (1) comprising one or more processor units;
a second chip component (2) comprising one or more integrated passive devices (21) and one or more memories, wherein at least one of the integrated passive devices (21) is connected to at least one of the processor units, and at least one of the memories is connected to at least one of the processor units.

2. The chip according to claim 1, wherein the first chip component (1) and the second chip component (2) are arranged in stack, and at least one of the integrated passive devices (21) is arranged facing at least one of the processor units.

3. The chip according to claim 2, wherein the second chip component (2) comprises a power gating cell (23), at least one of the processor units is a central processing unit (11), and the power gating cell (23) is arranged facing the central processing unit (11) and connected to the central processing unit (11),
wherein the central processing unit (11) comprises a first portion (111) and a second portion (112), the power gating cell (23) is arranged facing the first portion (111) and connected to the first portion (111), and at least one of the integrated passive devices (21) is a first integrated passive device (211) that is arranged facing the second portion (112) and connected to the second portion (112); and
the first integrated passive device (211) is integrated with the power gating cell (23) to form a first integrated unit (201).

4. The chip according to claim 2, wherein there is more than one integrated passive device (21), at least one of the more than one integrated passive devices (21) is a second integrated passive device (212), the first chip component (1) comprises at least one interface (14), and the second integrated passive device (212) is arranged facing the interface (14) and connected to the interface (14).

5. The chip according to claim 2, wherein at least one of the processor units is a graphics processing unit (12), at least one of the memories is a dynamic random access memory (22) that is arranged facing the graphics processing unit (12) and connected to the graphics processing unit (12); and/or
at least one of the processor units is a neural network processing unit (13), and the second chip component (2) further comprises a processing in memory module (24) that is arranged facing the neural network processing unit (13) and connected to the neural network processing unit (13).

6. The chip according to any one of claims 2-5, wherein the first chip component (1) and the second chip component (2) are connected through hybrid bonding,
preferably, there is more than one second chip component (2), and the more than one second chip components (2) are arranged on a same side of the first chip component (1) in a thickness direction of the chip and is arranged in stack.

7. The chip according to claim 1, wherein at least one of the processor units is a graphics processing unit (12), at least one of the memories is a dynamic random access memory (22), and the dynamic random access memory (22) is connected to the graphics processing unit (12).

8. The chip according to claim 7, wherein the chip comprises a first chip layer (101), a second chip layer (102) and a third chip layer (103) that are sequentially arranged in stack, the graphics processing unit (12) is arranged in the first chip layer (101), the dynamic random access memory (22) comprises a peripheral circuit (221) and a memory cell array (222), the peripheral circuit (221) is arranged in the second chip layer (102), and the memory cell array (222) and the integrated passive devices (21) are both arranged in the third chip layer (103); and
the peripheral circuit (221) is arranged facing the graphics processing unit (12) and connected to the graphics processing unit (12), and the memory cell array (222) is arranged facing the peripheral circuit (221) and connected to the peripheral circuit (221).

9. The chip according to claim 8, wherein there is more than one processor unit, and at least one of the more than one processor units is a central processing unit (11); and
the central processing unit (11) comprises a first cache portion (113) and a second cache portion (114), the first cache portion (113) is arranged in the first chip layer (101), the second cache portion (114) is arranged in the second chip layer (102), and the second cache portion (114) is arranged facing the first cache portion (113) and connected to the first cache portion (113),
wherein the second chip component (2) comprises a power gating cell (23) that is arranged in the third chip layer (103), and the power gating cell (23) is arranged facing the second cache portion (114) and connected to the second cache portion (114),
wherein the second cache portion (114) comprises a first sub-portion and a second sub-portion, the power gating cell (23) is arranged facing the first sub-portion and connected to the first sub-portion, at least one of the integrated passive devices (21) is a first integrated passive device (211) that is arranged facing the second sub-portion and connected to the second sub-portion, and the first integrated passive device (211) is integrated with the power gating cell (23) to form a second integrated unit (202).

10. The chip according to claim 8, wherein the first chip component (1) comprises at least one interface (14) that is arranged in the first chip layer (101), and at least one of the integrated passive devices (21) is a second integrated passive device (212) that is arranged facing the interface (14) and connected to the interface (14).

11. The chip according to claim 8, wherein there is more than one processor unit, at least one of the more than one processor units is a neural network processing unit (13) that is arranged in the first chip layer (101), the second chip component (2) further comprises a processing in memory module (24) that is arranged in the second chip layer (102), the processing in memory module (24) is arranged facing the neural network processing unit (13) and connected to the neural network processing unit (13), and the processing in memory module (24) is integrated with the peripheral circuit (221) to form a third integrated unit (203).

12. The chip according to claim 8, wherein there is more than one third chip layer (103), and the more than one third chip layers (103) are arranged on a same side of the second chip layer (102) in a thickness direction of the chip and is arranged in stack.

13. The chip according to any one of claims 8-12, wherein the first chip layer (101) and the second chip layer (102) are connected through hybrid bonding; and
the second chip layer (102) and the third chip layer (103) are connected through hybrid bonding.

14. The chip according to claim 5 or 7, wherein the integrated passive device (21) is in power ground connection with the first chip component (1), and the dynamic random access memory (22) is in signal ground connection with the first chip component (1).

15. An electronic device, comprising:
a circuit board; and
a chip, wherein the chip is a chip according to any one of claims 1-14 and is connected to the circuit board.
